# EUROPEAN PATENT APPLICATION

(11) **EP 1 892 769 A2**
(43) Date of publication of application: **27.02.2008**
(21) Application number: 07114598.1
(22) Date of filing: 20.08.2007
(51) Int. Cl.: H01L 31/0352, H01L 31/18, H01L 31/0392

(54) **Single conformal junction nanowire photovoltaic devices**

(30) Priority: 25.08.2006 US 510087
(71) Applicant: General Electric Company, Schenectady, NY 12345 (US)
(72) Inventor: Tsakalakos, Loucas, Niskayuna, NY 12309 (US); Korevaar, Bastian Arie, Schenectady, NY 12305 (US); Fronheiser, Jody Alan, Selkirk, NY 12158 (US); Balch, Joleyn Eileen, Schaghticoke, NY 12154 (US)
(74) Representative: Bedford, Grant Richard

(57) **Abstract**

In some embodiments, the present invention is directed to photovoltaic devices (e.g., solar cells) comprising elongated nanostructures coated with a thin conformal coating. Typically, such a conformal coating provides a substantially continuous charge separating junction. Depending on the embodiment, such devices can comprise a p-n junction, a p-i-n junction (with a thin intrinsic tunneling layer in between the p and n layers), and/or a heterojunction. In all cases, however, the elongated nanostructures are active photovoltaic (PV) elements in the photovoltaic device. Additionally, the present invention is also directed at methods of making and using such devices. Such photovoltaic or solar cell devices are likely to have cost parity with thin film solar cells, but with higher efficiency due to a charge separating junction that is conformal. Additionally, the nanostructures provide excellent light trapping and optical absorption properties.

## Description

The present invention relates generally to photovoltaic devices, and specifically to photovoltaic devices comprising elongated nanostructures and a conformally-derived junction.

Presently, silicon (Si) is the most commonly used material in the fabrication of solar cells, such solar cells being used for converting sunlight into electricity. Single and multi-junction p-n solar cells are used for this purpose, but none are efficient enough to drive down the costs involved in the production and use of this technology. Consequently, competition from conventional sources of electricity precludes the widespread use of such solar cell technology.

The primary loss process in existing solar cells occurs when a photo-excited electron quickly loses any energy it may have in excess of the bandgap to lattice vibrations, known as phonons, resulting in an increased recombination rate. This loss alone limits the conversion efficiency of a standard cell to about 44%. Additionally, recombination of photo-generated electrons and holes with trap states in the semiconductor crystal associated with point defects (interstitial impurities), metal clusters, line defects (dislocations), planar defects (stacking faults), and/or grain boundaries reduces the efficiency further. Although this latter reduction in efficiency can be overcome by using other materials with appropriate properties, particularly long diffusion lengths of the photo-generated carriers, this still does not bring this technology to a cost parity with more conventional sources of electricity. Further loss is incurred owing to the fact that semiconductors will not absorb light with energy lower than the bandgap of the material used. With all of the photovoltaic losses taken into account, Shockley and Queisser were able to show that the performance of a single junction cell was limited to just over 30 percent efficiency for an optimal cell with a bandgap of 1.3 electron volts (eV) (Shockley and Queisser, "Detailed Balance Limit of Efficiency of p-n Junction Solar Cells," J. Appl. Phys., 1961, 32(3), pp. 510-519). More recent calculations have shown this "limit efficiency" for a single junction to be 29 percent (Kerr et al., "Lifetime and efficiency of limits of crystalline silicon solar cells," Proc. 29th IEEE Photovoltaic Specialists Conference, 2002, pp. 438-441).

Efforts to utilize nanowires and other similar such nanostructures have been investigated with the aim of improving solar cell efficiency. These efforts are briefly described below.

Silicon nanowires have been described in p-n junction diode arrays (Peng et al., "Fabrication of large-Area Silicon Nanowire p-n Junction Diode Arrays," Adv. Mater., 2004, vol. 16, pp. 73-76). Such arrays, however, were not configured for use in photovoltaic devices, nor was it suggested how such arrays might serve to increase the efficiency of solar cells.

Silicon nanostructures have been described in solar cell devices (Ji et al., "Silicon Nanostructures by Metal Induced Growth (MIG) for Solar Cell Emitters," Proc. IEEE, 2002, pp. 1314-1317). In such devices, Si nanowires can be formed, embedded in microcrystalline Si thin films, by sputtering Si onto a nickel (Ni) pre-layer, the thickness of which determines whether the Si nanowires grow inside the film or not. However, such nanowires are not active PV elements; they merely serve in an anti-reflective capacity.

Solar cells comprising silicon nanostructures, where the nanostuctures are active PV elements, have been described in commonly-assigned co-pending United States Patent Application Serial No. 11/081,967, filed March 16, 2005. In that particular Application, the charge separating junctions are largely contained within the nanostructures themselves, generally requiring doping changes during the synthesis of such nanostructures.

As a result of the foregoing, any modifications of such solar cell technology, particularly modifications incorporating nanoscale materials and devices, that lead to further improvements and efficiencies on par with the more traditional sources of electricity, would be entirely beneficial.

In some embodiments, the present invention is directed to photovoltaic devices (e.g., solar cells) comprising elongated nanostructures coated with a thin conformal coating. Depending on the particular embodiment, such devices may comprise a p-n junction, a p-i-n junction, and/or a heterojunction. In all cases, however, at least some of the elongated nanostructures are active photovoltaic (PV) elements in the photovoltaic device. Additionally, certain aspects of the present invention are also directed at methods of making and using such devices. Such photovoltaic or solar cell devices are likely to have cost parity with thin film solar cells, but with with potentially higher efficiency due to the fact that optical absorption can be separated from charge transport since most charge carriers are generated near or within the depletion region, quickly separating the charge carriers, thus reducing the chance of recombination, while strong light trapping minimizes the thickness required to absorb light. In some such embodiments, this is a single conformal junction or a substantially continuous conformal junction. Additionally, the nanostructures provide excellent light trapping and optical absorption properties.

In some embodiments, the present invention is directed to a p-n type photovoltaic device comprising: (a) a plurality of elongated nanostructures emanating from a porous nanotemplate, the elongated nanostructures being comprised of a semiconducting material having a doping of a first type; (b) a conformal layer of semiconducting material disposed conformally about the plurality of elongated nanostructures, the conformal layer of semiconducting material having a doping of a second type and, together with the plurality of elongated nanostructures, providing for a charge separating junction; (c) a conductive transparent material disposed on the conformal layer; and (d) top and bottom contacts operable for connecting the device to an external circuit, wherein the bottom contact is in electrical contact with the plurality of elongated nanostructures and the top contact is in electrical contact with the conformal layer.

In some embodiments, the present invention is directed to a method of making a p-n type photovoltaic device, the method comprising the steps of: (a) growing elongated nanostructures which emanate from a porous nanotemplate, the elongated nanostructures comprising a semiconducting material and having a doping of a first type; (b) depositing a conformal layer of semiconducting material conformally about the plurality of elongated nanostructures, the conformal layer of semiconducting material having a doping of a second type so as to form a charge separating junction with the underlying elongated nanostructures; (c) depositing a conductive transparent material on the conformal layer; and (d) establishing top and bottom contacts operable for connecting the device to an external circuit, wherein the bottom contact is in electrical contact with the plurality of elongated nanostructures and the top contact is in electrical contact with the conformal layer.

In some embodiments, the present invention is directed to a (pseudo) p-i-n type photovoltaic device, wherein the intrinsic layer serves more as a surface passivating layer for which intrinsic a-Si does better than doped amorphous silicon. In such embodiments, this intrinsic layer is kept sufficiently thin that the charge carriers can tunnel through them. Some such p-i-n photovoltaic devices comprise: (a) a plurality of elongated nanostructures emanating from a porous nanotemplate, the elongated nanostructures being comprised of a semiconducting material having a doping of a first type; (b) a first conformal layer of intrinsic semiconducting material disposed conformally about the plurality of elongated nanostructures; (c) a second conformal layer of semiconducting material disposed conformally about the first conformal layer, the second conformal layer having a doping of a second type, thereby providing for a charge separating junction; (d) a conductive transparent material disposed on the second conformal layer; and (e) top and bottom contacts operable for connecting the device to an external circuit, wherein the bottom contact is in electrical contact with the plurality of nanowires and the top contact is in electrical contact with the second conformal layer.

In some embodiments, the present invention is directed to a method of making a (pseudo) p-i-n photovoltaic device (see device description above), the method comprising the steps of: (a) growing elongated nanostructures which emanate from a porous nanotemplate, the elongated nanostructures comprising a semiconducting material and having a doping of a first type; (b) depositing a first conformal layer of intrinsic semiconducting material conformally about the plurality of elongated nanostructures; (c) depositing a second conformal layer of semiconducting material conformally about the first conformal layer, the second conformal layer having a doping of a second type so as to establish a charge separating junction together with the elongated nanostructures and the first conformal layer; (d) depositing a conductive transparent material on the second conformal layer; and (e) establishing top and bottom contacts operable for connecting the device to an external circuit, wherein the bottom contact is in electrical contact with the plurality of elongated nanostructures and the top contact is in electrical contact with the second conformal layer.

In some embodiments, the present invention is directed to a heterojunction-based photovoltaic device comprising: (a) a plurality of elongated nanostructures emanating from a porous nanotemplate, the elongated nanostructures being comprised of a semiconducting material having a first bandgap; (b) a conformal layer of semiconducting material disposed conformally about the plurality of elongated nanostructures, the conformal layer of semiconducting material having a second bandgap and, together with the plurality of elongated nanostructures, providing for a charge separating heterojunction; (c) a conductive transparent material disposed on the conformal layer; and (d) top and bottom contacts operable for connecting the device to an external circuit, wherein the bottom contact is in electrical contact with the plurality of elongated nanostructures and the top contact is in electrical contact with the conformal layer.

In some embodiments, the present invention is directed to a method of making a heterojunction-based photovoltaic device, the method comprising the steps of: (a) growing elongated nanostructures which emanate from a porous nanotemplate, the elongated nanostructures comprising a semiconducting material and having a first bandgap; (b) depositing a conformal layer of semiconducting material conformally about the plurality of elongated nanostructures, the conformal layer of semiconducting material having a second bandgap so as to form a charge separating heterojunction with the underlying elongated nanostructures; (c) depositing a conductive transparent material on the conformal layer; and (d) establishing top and bottom contacts operable for connecting the device to an external circuit, wherein the bottom contact is in electrical contact with the plurality of elongated nanostructures and the top contact is in electrical contact with the conformal layer.

The foregoing has outlined rather broadly the features of the present invention in order that the detailed description of the invention that follows may be better understood.

For a more complete understanding of the present invention, and the advantages thereof, reference is now made to the following descriptions taken in conjunction with the accompanying drawings, in which:

FIGURE 1 depicts a p-n junction photovoltaic (PV) device comprising elongated nanostructures, in accordance with some embodiments of the present invention;

FIGURE 2 depicts a conductive layer on which the elongated nanostructures reside, and being operable as a bottom contact, where such a conductive layer may comprise a conductive region (106a) and a non-conductive region (106b);

FIGURE 3 depicts, in stepwise fashion, a method of fabricating a p-n junction PV device, in accordance with some embodiments of the present invention;

FIGURE 4 depicts a p-n junction photovoltaic (PV) device comprising elongated nanostructures, in accordance with some embodiments of the present invention;

FIGURE 5 depicts, in stepwise fashion, a method of fabricating a p-n junction PV device, in accordance with some embodiments of the present invention;

FIGURE 6 depicts a p-n junction photovoltaic (PV) device comprising elongated nanostructures, in accordance with some embodiments of the present invention;

FIGURE 7 depicts in stepwise fashion, a method of fabricating a p-n junction PV device, in accordance with some embodiments of the present invention;

FIGURE 8 is a scanning electron microscopy (SEM) micrograph of a conformal amorphous Si layer on a Si nanowire array formed via an etching technique;

FIGURE 9 is a transmission electron microscopy (TEM) micrograph (and corresponding energy dispersive X-ray spectra) depicting a coated Si nanowire of the type shown in FIGURE 8;

FIGURE 10 is a scanning electron micrograph of a conformal amorphous Si layer on a Si nanowire array formed via chemical vapor deposition (CVD);

FIGURE 11 is a transmission electron micrograph (and corresponding energy dispersive X-ray spectra) depicting a coated Si nanowire of the type shown in FIGURE 10;

FIGURES 12A and 12B depict total reflectance (12A) and transmission (12B) data for an 11 mm thick solid Si thin film and a nanowire film on a glass substrate, in accordance with some embodiments of the present invention;

FIGURE 13 depicts total absorption data for an 11 mm thick solid Si thin film and a nanowire film on a glass substrate, wherein the inset shows a cross-sectional scanning electron micrograph of the sample; and

FIGURE 14 depicts total optical absorption data for CVD-grown nanowire samples grown on glass using a catalyst thickness of (a) 50 Å, (b) 25 Å, and (c) 10 Å showing enhanced absorption of the nanowire samples compared to (d) a solid Si film; Absorption data for a 50 Å thick Au film on glass (e) before and (f) after thermal annealing at the same temperature and time as the nanowire growth (though without silane flow); and (g) absorption data for a glass substrate similar to that used in the above samples.

In some embodiments, the present invention is directed to photovoltaic devices (e.g., solar cells) comprising elongated nanostructures coated with a thin conformal coating. Depending on the embodiment, such devices can comprise a p-n junction, a p-i-n junction, and/or a heterojunction. In all cases, however, at least some of the elongated nanostructures are active photovoltaic (PV) elements in the photovoltaic device. Additionally, the present invention is also directed at methods of making and using such devices. Such photovoltaic or solar cell devices are likely to have cost parity with thin film solar cells, but with higher efficiency due to the generation of charge carriers near or within the depletion region and thus a very effective separation of the charge carrier, reducing the recombination of charge carriers. Additionally, the nanostructures provide excellent light trapping and optical absorption properties.

In the following description, specific details are set forth such as specific quantities, sizes, etc. so as to provide a thorough understanding of embodiments of the present invention. However, it will be obvious to those skilled in the art that the present invention may be practiced without such specific details. In many cases, details concerning such considerations and the like have been omitted inasmuch as such details are not necessary to obtain a complete understanding of the present invention and are within the skills of persons of ordinary skill in the relevant art. Referring to the drawings in general, it will be understood that the illustrations are for the purpose of describing a particular embodiment of the invention and are not intended to limit the invention thereto.

While most of the terms used herein will be recognizable to those of skill in the art, the following definitions are nevertheless put forth to aid in the understanding of the present invention. It should be understood, however, that when not explicitly defined, terms should be interpreted as adopting a meaning presently accepted by those of skill in the art.

A "photovoltaic device," as defined herein, is a device comprising at least one photodiode and which utilizes the photovoltaic effect to produce an electromotive force (e.m.f.). See Penguin Dictionary of Electronics, Third Edition, V. Illingworth, Ed., Penguin Books, London, 1998. An exemplary such device is a "solar cell," wherein a solar cell is a photodiode whose spectral response has been optimized for daytime radiation from the sun.

"Nanoscale," as defined herein, generally refers to dimensions below 1 µm.

"Nanostructures," as defined herein, generally refer to structures that are nanoscale in at least two dimensions.

"Elongated nanostructures," as defined herein, are nanostructures that are nanoscale in two dimensions.

"Nanowires," as defined herein, are generally elongated nanostructures having a largely cylindrical shape and typically being sub-micron (< 1 µm) in at least two dimensions.

"Conformal," as defined herein and pertaining to coatings that cover the surfaces of a substantially non-perpendicular structure such as a microfabricated trench, nanowire, etc., but which largely adopt the shape (i.e., they conform to) of the underlying structure. This term should be interpreted broadly, however, permitting the substantial filling of void space between the coated structures-at least in some embodiments.

"Semiconducting material," as defined herein, is material that has a conductivity that is generally intermediate between metals and insulators, and wherein such a material has an energy gap, or "bandgap," between its valence and conduction bands. In its pure, undoped state, such semiconducting material is typically referred to as being "intrinsic."

"p-doping," as defined herein, refers to doping of semiconducting material with impurities that introduce holes effective for increasing the conductivity of the intrinsic semiconducting material and moving the Fermi level towards the valence band such that a junction can be formed.. An exemplary such p-doping is the addition of small quantities of boron (B) to silicon (Si).

"n-doping," as defined herein, refers to doping of semiconducting material with impurities that introduce electrons effective for increasing the conductivity of the intrinsic semiconducting material and moving the Fermi level towards the conduction band such that a junction can be formed. An exemplary such n-doping is the addition of small quantities of phosphorous (P) to silicon (Si).

A "charge separating junction" is defined herein as a boundary between two materials of opposite doping type, the junction allowing for separation of minority charge carriers on one side of the boundary to the other side of the boundary in which they are majority charge carriers.

"Active PV elements," as defined herein, are those elements of a PV device responsible for establishing a charge-separating junction.

A "p-n photovoltaic device," as defined herein, is a device comprising at least one photodiode comprising a charge-separating junction established via the contact of a p-doped semiconductor and an n-doped semiconductor.

A "p-i-n photovoltaic device," as defined herein, is a device comprising at least one photodiode comprising a charge separating junction established via the layering of a p-doped semiconductor, an intrinsic (i-type) semiconductor, and an n-type semiconductor, wherein the i-type semiconductor is positioned between the p-doped semiconductor and the n-doped semiconductor, and wherein the i-type semiconductor serves as an intrinsic tunneling layer.

A "heterojunction photovoltaic device," as defined herein, is a device comprising at least one photodiode comprising a charge separating junction established via the contact of two differing semiconductor materials having differing bandgaps, typically with an offset in the conduction and valence band edges in one of several configurations; i.e., Type I, Type II, or staggered.

"Porous nanotemplates," as defined herein, are inorganic or organic films comprising an array of pores or columns having nanoscale dimensions.

### p-n Devices

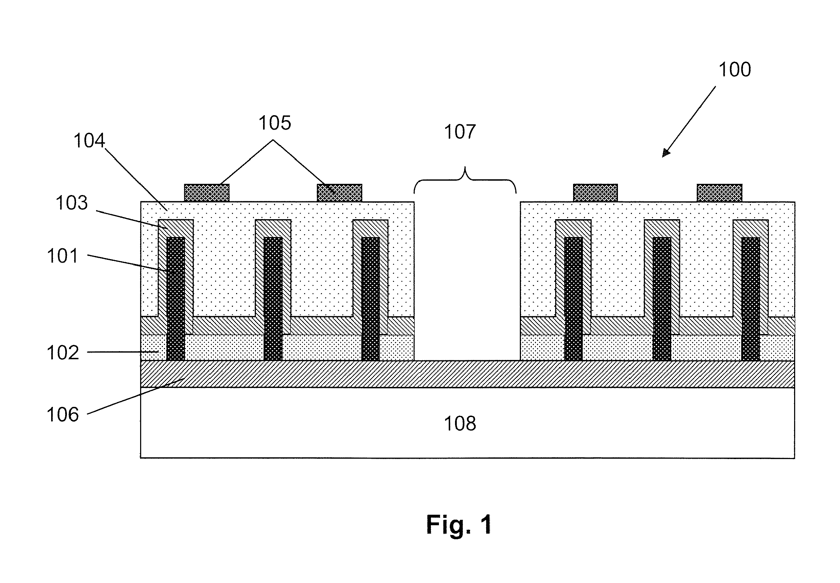

Referring to FIGURE 1, in some embodiments, the present invention is directed to a p-n type photovoltaic device 100 comprising: (a) a plurality of elongated nanostructures 101 emanating from a porous nanotemplate 102, the elongated nanostructures being comprised of a semiconducting material having a doping of a first type; (b) a conformal layer 103 of semiconducting material disposed conformally about the plurality of elongated nanostructures 101, the conformal layer of semiconducting material having a doping of a second type and, together with the plurality of elongated nanostructures, providing for a charge separating junction; (c) a conductive transparent material 104 disposed on the conformal layer 103; and (d) top (105) and bottom (106) contacts operable for connecting the device to an external circuit, wherein the bottom contact(s) 106 is in electrical contact with the plurality of elongated nanostructures and the top contact(s) 105 is in electrical contact with the conformal layer.

Generally, the elongated nanostructures 101 are selected from the group consisting of nanowires, nanorods, nanotubes, and similar nanostructures, and combinations thereof. Typically, the elongated nanostructures emanate from the porous nanotemplate 102 with a substantially vertical orientation, "substantially vertical" meaning that at least a majority of the nanostructures form an angle with the substrate and/or template that is greater than 45°. However, the elongated nanostructures can also emanate from the porous nanotemplate with a random orientation. Typically, the elongated nanostructures have a diameter between about 1 nm and about 1 µm, and wherein the elongated nanostructures have a length between about 100 nm and about 100 µm. Regarding the doping of a first type, the elongated nanostructures possess a doping selected from the group consisting of p-doped and n-doped, the only stipulation being that the doping of the first type be different from the doping of the second type. Typically, the elongated nanostructures are p-doped.

In some embodiments, the above-described photovoltaic device further comprises a substrate 108 on which porous nanotemplate resides. In some embodiments, the substrate comprises a conductive material selected from the group consisting of metal and degenerately-doped silicon. In some such embodiments, the bottom contact 106 is integral with the substrate 108. In some embodiments, the substrate comprises a non-conductive material selected from the group consisting of glass and ceramics, on which the bottom contact 106 resides.

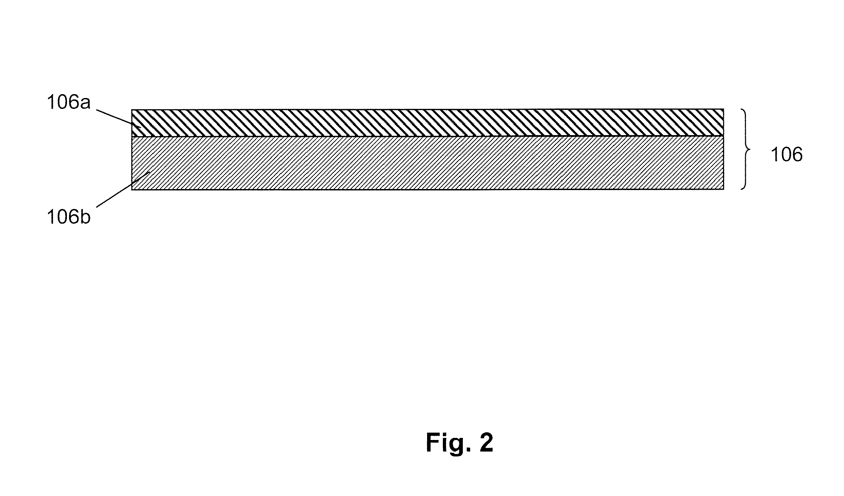

Referring to FIGURE 2, in some embodiments, the bottom contact 106 comprises multiple layers, as in, for example, layers 106a and 106b. Such multiple layers may have a bearing on how the nanoporous template 102 adheres to the substrate 108 and/or may be dependent upon the technique used to fabricate the device (vide infra).

In some embodiments, the elongated nanostructures 101 comprise a semiconducting material selected from the group consisting of silicon (Si), SiGe, gallium arsenide (GaAs), gallium phosphide (GaP), indium phosphide (InP), GaInP, germanium (Ge), GaInAs, aluminum gallium arsenide (AlGaAs), zinc oxide (ZnO), gallium nitride (GaN), aluminum nitride (AIN), indium nitride (InN), boron nitride (BN), selenium (Se), cadmium selenide (CdSe), cadmium telluride (CdTe), Cd-O-Te, Cd-Mn-O-Te, ZnTe, Zn-O-Te, Zn-Mn-O-Te, MnTe, Mn-O-Te, oxides of copper, carbon, Cu-In-Ga-Se, Cu-In-Se, and similar compositions, and combinations thereof. Exemplary such materials of which the elongated nanostructures are typically fabricated include Si and/or CdTe.

In some embodiments, the porous nanotemplate 102 comprises a material selected from the group consisting of anodized aluminum oxide (AAO), silicon dioxide (SiO₂), boron nitride (BN), silicon nitride (Si₃N₄), and the like. In some embodiments, the porous nanotemplate comprises a thickness (or an average thickness) of between about 0.1 µm and about 100 µm, wherein the porous nanotemplate comprises a pore diameter (or an average diameter) of between about 1 nm and about 1 µm, and wherein the porous nanotemplate comprises a pore density between about 10⁵ per cm² and about 10¹¹ per cm².

Depending on the embodiment, device 100 can generally be configured for illumination from the top, the bottom, or both. Generally, bottom (or backside) illumination requires that the substrate 108, bottom contact 106, and nanoporous template 102 be transparent. Note that the terms "top" and "bottom" relate to the devices as illustrated, and not necessarily to their orientation as used.

Depending on the embodiment, the conformal layer 103 can be either n-doped or p-doped (see above). Generally, the conformal layer is at least substantially continuous, but is, at least in some embodiments, permitting of discontinuity. Generally, such conformal layers on the elongated nanostructures afford greater fault tolerance to the device. Notwithstanding the difference in doping, the conformal layer of such p-n devices is generally of the same semiconducting material as the elongated nanostructures, although differences may exist in their crystallinity (e.g., crystalline or amorphous). Typically, the conformal layer is n-doped.

In some embodiments, the conformal layer 103 comprises a semiconducting material selected from the group consisting of silicon, GaAs, GaP, InP, GaInP, Ge, SiGe, GaInAs, AlGaAs, ZnO, GaN, AIN, InN, BN, Se, CdSe, CdTe, CdS, Cd-O-Te, Cd-Mn-O-Te, ZnTe, Zn-O-Te, Zn-Mn-O-Te, MnTe, Mn-O-Te, oxides of copper, carbon, titanium oxide, Cu-In-Ga-Se, Cu-In-Se, and similar such compositions, and combinations thereof. More particularly, in some embodiments, the conformal layer comprises a semiconducting material selected from the group consisting of amorphous silicon, nanocrystalline silicon, amorphous SiGe, amorphous SiC, and combinations thereof. Generally, however, conformal layer 103, while having a doping that is opposite to that of the elongated nanostructures 101, comprises the same bulk composition as the nanostructures. Typically, the conformal layer comprises a thickness between about 1 nm and about 100 nm.

Typically, the conductive transparent material 104 substantially fills the void space between conformally-coated nanostructures with device 100. In some embodiments, the conductive transparent material is a transparent conductive oxide (TCO). In some such embodiments, the transparent conductive oxide is indium-tin-oxide (ITO). In some other such embodiments, the transparent conductive oxide is doped ZnO. Typically, the conductive transparent material comprises a thickness between about 0.05 µm and about 1 µm.

### Method of Fabricating p-n Devices

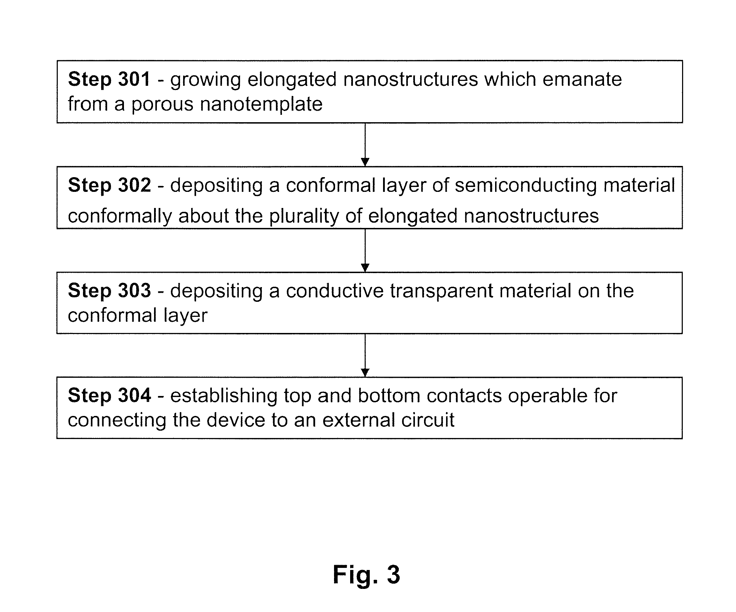

Referring to FIGURE 3, in some embodiments, the present invention is directed to a method of making a p-n type photovoltaic device, such as described above (i.e., device 100), the method comprising the steps of: (Step 301) growing elongated nanostructures which emanate from a porous nanotemplate, the elongated nanostructures comprising a semiconducting material and having a doping of a first type; (Step 302) depositing a conformal layer of semiconducting material conformally about the plurality of elongated nanostructures, the conformal layer of semiconducting material having a doping of a second type so as to form a charge separating junction with the underlying elongated nanostructures; (Step 303) depositing a conductive transparent material on the conformal layer; and (Step 304) establishing top and bottom contacts operable for connecting the device to an external circuit, wherein the bottom contact is in electrical contact with the plurality of elongated nanostructures and the top contact is in electrical contact with the conformal layer.

In some embodiments, the nanotemplate resides on a substrate, the substrate either providing or supporting the bottom contact, i.e., substrate 108 either supports bottom contact 106, or is integral with it (see FIGURE 1).

In some embodiments, the elongated nanostructures are grown by a method selected from the group consisting of chemical vapor deposition (CVD), metal-organic CVD (MOCVD), plasma enhanced CVD (PECVD), hot wire CVD (HWCVD), atomic layer deposition, electrochemical deposition, solution-based chemical deposition, and similar such methods, and combinations thereof. For exemplary methods of growing elongated nanostructures in AAO templates, see Bogart et al., "Diameter-Controlled Synthesis of Silicon Nanowires Using Nanoporous Alumina Membranes," Adv. Mater., 2005, 17(1), pp. 114-117, and references 17-22 contained therein. For other methods of generating such elongated nanostructures, see Zhang et al., "Synthesis of Ordered Single Crystal Silicon Nanowire Arrays," Adv. Mater., 2001, 13(16), pp. 1238-1241; Cheng et al., "Highly ordered nanostructures of single crystalline GaN nanowires in anodic alumina membranes," Mater. Sci. & Eng., 2000, A286, pp. 165-168; and Zhang et al., "Fabrication of Highly Ordered InSb Nanowire arrays by Electrodeposition in Porous Anodic Alumina Membranes," J. Electrochem. Soc., 2005, 152(10), pp. C664-C668.

In some embodiments, the elongated nanostructures are catalytically grown from metal nanoparticles or metal films, the latter typically residing underneath a porous nanotemplate. In some such embodiments, the metal nanoparticles or metal films comprise a metal selected from the group consisting of gold (Au), cobalt (Co), nickel (Ni), indium (In), gallium (Ga), aluminum (Al), iron (Fe), and similar such metals and combinations and/or alloys thereof, the choice of metal being dependent on the elongated nanostructure to be grown.

In some embodiments, the above-described metal nanoparticles are initially provided at the bottom of the porous nanotemplate. In some such embodiments, the metal nanoparticles are provided by an electrodeposition process.

In some embodiments, there exists a further step of etching back the nanoporous template so as to more fully expose the elongated nanostructures such that they properly emanate from the nanoporous template (see above).

In some embodiments, the conformal layer is deposited by a method selected from the group consisting of CVD, MOCVD, PECVD, HWCVD, sputtering, atomic layer deposition, electrochemical deposition, similar such methods, and combinations thereof.

Doping of the nanostructures and the conformal layer is generally carried out during their synthesis/deposition. In some embodiments, e.g., utilizing CVD, the doping is accomplished by introducing small amounts of a dopant gas such as diborane (B₂H₆), trimethylboron, or phosphine, as appropriate. Typically, the dopant level is controlled by the concentration of the dopant precursor gas in the mixture of gases supplied in the CVD reactor.

In some embodiments, the conductive transparent material is deposited on the conformal layer so as to substantially fill the voids between the nanowires coated with the conformal layer. In some embodiments, the conductive transparent material is deposited by a technique selected from the group consisting of sputtering, sol-gel spinning and pyrolysis, evaporation, CVD, MOCVD, other plasma deposition methods, and combinations thereof.

### p-i-n Devices (with thin intrinsic tunnel junction)

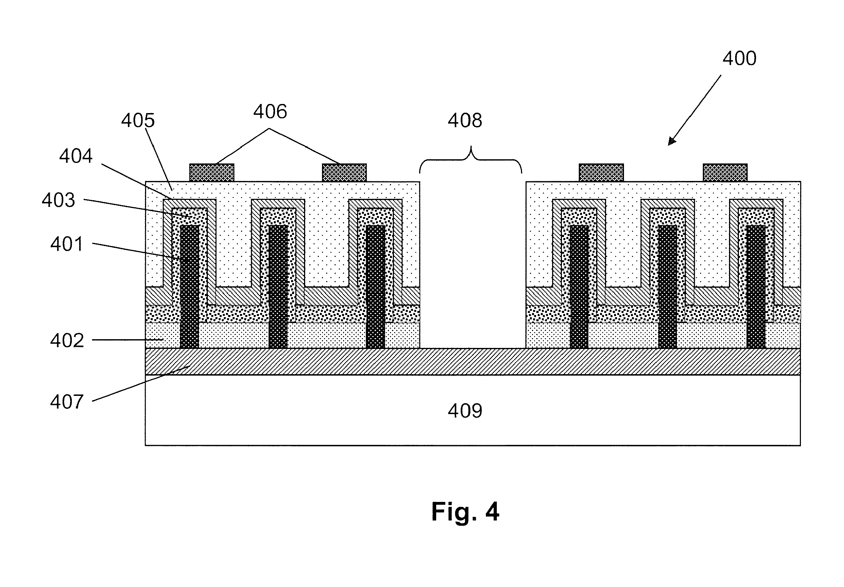

Referring to FIGURE 4, in some embodiments, the present invention is directed to a (pseudo) p-i-n type photovoltaic device 400 comprising: (a) a plurality of elongated nanostructures 401 emanating from a porous nanotemplate 402, the elongated nanostructures being comprised of a semiconducting material having a doping of a first type; (b) a first conformal layer 403 of intrinsic semiconducting material disposed conformally about the plurality of elongated nanostructures 401; (c) a second conformal layer 404 of semiconducting material disposed conformally about the first conformal layer 403, the second conformal layer having a doping of a second type, thereby providing for a charge separating junction; (d) a conductive transparent material 405 disposed on the second conformal layer 404; and (e) top (406) and bottom (407) contacts operable for connecting the device to an external circuit, wherein the bottom contact 407 is in electrical contact with the plurality of nanowires and the top contact 406 is in electrical contact with the second conformal layer.

In some embodiments, the elongated nanostructures 401 emanate from the porous nanotemplate 402 with a substantially vertical orientation (see above). Typically, the elongated nanostructures have a diameter between about 1 nm and about 1 µm, and have a length between about 100 nm and about 100 µm. Generally, the elongated nanostructures are either p-doped or n-doped.

In some embodiments, the elongated nanostructures 401 comprise a semiconducting material selected from the group consisting of silicon, GaAs, GaP, InP, GaInP, Ge, GaInAs, AlGaAs, ZnO, GaN, A1N, InN, BN, Se, CdSe, CdTe, Cd-O-Te, Cd-Mn-O-Te, ZnTe, Zn-O-Te, Zn-Mn-O-Te, MnTe, Mn-O-Te, oxides of copper, carbon, Cu-In-Ga-Se, Cu-In-Se, and similar materials, and combinations thereof.

In some embodiments, the porous nanotemplate 402 comprises a material selected from the group consisting of anodized aluminum oxide (AAO), SiO₂ BN, Si₃N₄, and similar such materials.

In some embodiments, the porous nanotemplate 402 comprises a thickness of between about 0.1 µm and about 100 µm, wherein the porous nanotemplate comprises a pore diameter of between about 1 nm and about 1 µm, and wherein the porous nanotemplate comprises a pore density between about 10⁵ per cm² and about 10¹¹ per cm².

Generally, the second conformal layer 404 is either n-doped or p-doped, requiring only that it be doped differently than that of the elongated nanostructures, and that the first conformal layer be undoped or intrinsic.

In some embodiments, the first (403) and second (404) conformal layers comprise a semiconducting material selected from the group consisting of silicon, GaAs, GaP, InP, GaInP, Ge, SiGe, GaInAs, AlGaAs, ZnO, GaN, AIN, InN, BN, Se, CdSe, CdTe, Cd-O-Te, Cd-Mn-O-Te, ZnTe, Zn-O-Te, Zn-Mn-O-Te, MnTe, Mn-O-Te, oxides of copper, carbon, Cu-In-Ga-Se, Cu-In-Se, similar such compositions, and combinations thereof. Notwithstanding the differences in doping, the elongated nanostructures and the first and second conformal layers all comprise the same semiconducting material.

In some embodiments, the first conformal layer 403 comprises a thickness between about 1 nm and about 50 nm, and the second conformal layer 404 comprises a thickness between about 1 nm and about 50 nm.

The conductive transparent material 405 generally substantially fills the void space between the conformally-coated elongated nanostructures. In some embodiments, the conductive transparent material is a transparent conductive oxide (TCO). In some such embodiments, the transparent conductive oxide is selected from the group consisting of indium-tin-oxide (ITO) and doped ZnO. In some such embodiments, the conductive transparent material comprises a thickness between about 0.05 µm and 1 µm.

### Methods of Fabricating p-i-n Devices (comprising a thin intrinsic tunnel junction)

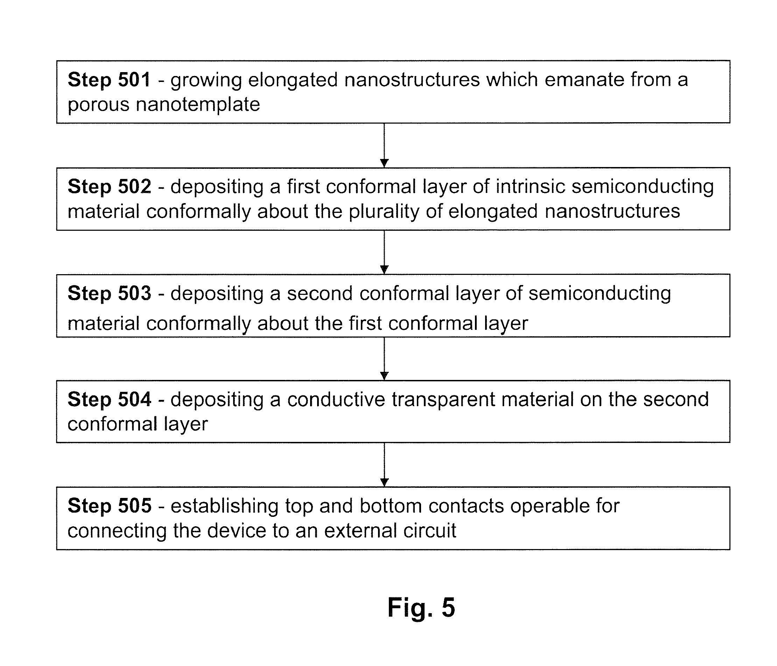

Referring to FIGURE 5, in some embodiments, the present invention is directed to a method of making a p-i-n photovoltaic device, such as the p-i-n device described above (device 400), the method comprising the steps of: (Step 501) growing elongated nanostructures which emanate from a porous nanotemplate, the elongated nanostructures comprising a semiconducting material and having a doping of a first type; (Step 502) depositing a first conformal layer of intrinsic semiconducting material conformally about the plurality of elongated nanostructures; (Step 503) depositing a second conformal layer of semiconducting material conformally about the first conformal layer, the second conformal layer having a doping of a second type so as to establish a charge separating junction together with the elongated nanostructures and the first conformal layer; (Step 504) depositing a conductive transparent material on the second conformal layer; and (Step 505) establishing top and bottom contacts operable for connecting the device to an external circuit, wherein the bottom contact is in electrical contact with the plurality of elongated nanostructures and the top contact is in electrical contact with the second conformal layer.

In some embodiments, the nanotemplate resides on a substrate, the substrate either providing or supporting the bottom contact. In the former embodiments, for example, substrate 409 is integral with bottom contact 407. As in the case of the p-n device described above, bottom contact 407 can have multiple layers.

In some embodiments, the elongated nanostructures are grown by a method selected from the group consisting of CVD, MOCVD, PECVD, HWCVD, atomic layer deposition, electrochemical deposition, solution-based chemical deposition, similar such methods, and combinations thereof.

In some embodiments, the elongated nanostructures are catalytically grown from metal nanoparticles or metal films, the latter of which may reside underneath the porous nanotemplate. In some such embodiments, the metal nanoparticles comprise a metal selected from the group consisting of gold (Au), cobalt (Co), nickel (Ni), indium (In), gallium (Ga), aluminum (Al), and combinations thereof. In some such embodiments, the metal nanoparticles are initially provided at the bottom of the porous nanotemplate.

In some embodiments, there is a further step of etching the porous nanotemplate so as to allow the elongated nanostructures to more properly emanate from the nanoporous template.

In some embodiments, the first and second conformal layers are deposited by a method selected from the group consisting of CVD, MOCVD, PECVD, HWCVD, sputtering, atomic layer deposition, and combinations thereof.

In some embodiments, the conductive transparent material is deposited on the second conformal layer so as to substantially fill the voids between the elongated nanostructures coated with the first and second conformal layers.

In some embodiments, the conductive transparent material is deposited using a technique selected from the group consisting of sputtering, sol-gel spinning and pyrolysis, evaporation, CVD, MOCVD, and combinations thereof.

### Heterojunction Device

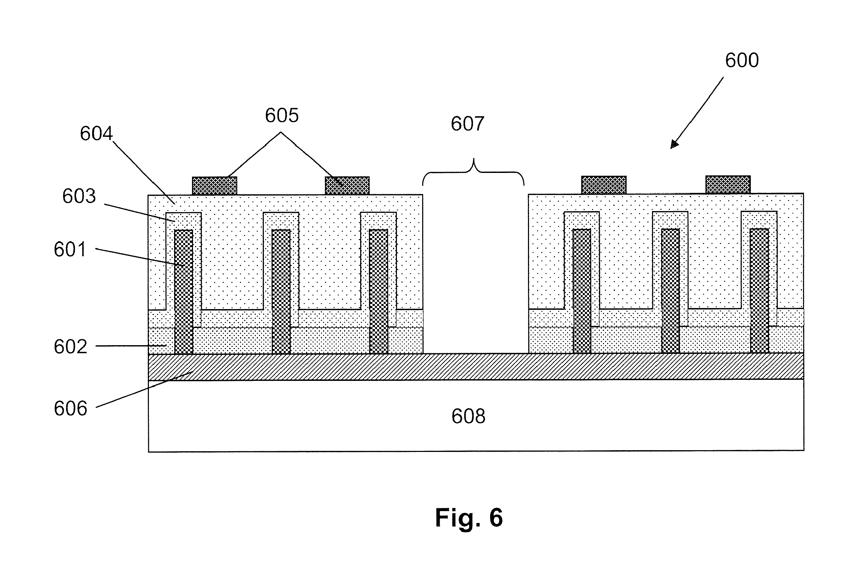

Referring to FIGURE 6, in some embodiments, the present invention is directed to a heterojunction-based photovoltaic device 600 comprising: (a) a plurality of elongated nanostructures 601 emanating from a porous nanotemplate 602, the elongated nanostructures being comprised of a semiconducting material having a first bandgap; (b) a conformal layer 603 of semiconducting material disposed conformally about the plurality of elongated nanostructures, the conformal layer of semiconducting material having a second bandgap and, together with the plurality of elongated nanostructures, providing for a charge separating heterojunction; (c) a conductive transparent material 604 disposed on the conformal layer 603; and (d) top (605) and bottom (606) contacts operable for connecting the device to an external circuit, wherein the bottom contact 606 is in electrical contact with the plurality of elongated nanostructures and the top contact 605 is in electrical contact with the conformal layer.

Such above-described heterojunction devices (600) are largely similar (both structurally and operatively) to the p-n devices (100) described above, except that the material(s) of which elongated nanostructures 601 and conformal layer 603 are comprised are necessarily different, and at least one of which is doped or naturally doped. Additionally, intentional doping of such materials is typically not required, though may be necessary depending on the materials used. Exemplary pairs of materials that may form a heterojunction device include, but are not limited to, CdTe/CdS, CdTe/CdSe, CuInS₂/TiO₂, and Cu(In,Ga)Se₂/CdS.

### Method of Fabricating Heterojunction Devices

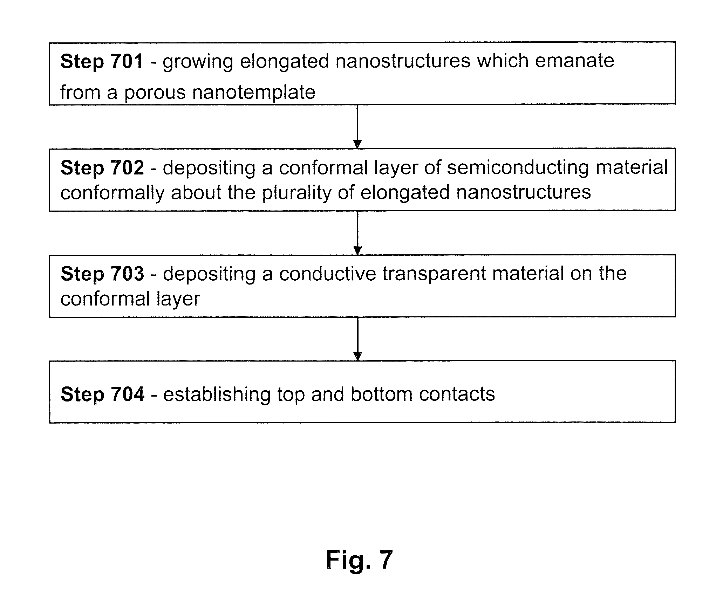

Referring to FIGURE 7, in some embodiments, the present invention is directed to a method of making a heterojunction-based photovoltaic device, the method comprising the steps of: (Step 701) growing elongated nanostructures which emanate from a porous nanotemplate, the elongated nanostructures comprising a semiconducting material and having a first bandgap; (Step 702) depositing a conformal layer of semiconducting material conformally about the plurality of elongated nanostructures, the conformal layer of semiconducting material having a second bandgap so as to form a charge separating heterojunction with the underlying elongated nanostructures; (Step 703) depositing a conductive transparent material on the conformal layer; and (Step 704) establishing top and bottom contacts operable for connecting the device to an external circuit, wherein the bottom contact is in electrical contact with the plurality of elongated nanostructures and the top contact is in electrical contact with the conformal layer.

Fabrication of the above-described heterojunction devices largely parallels that of the p-n devices described earlier. A notable exception, however, is that doping of the materials is typically unnecessary.

### Variations

A number of variations exist for the above-described devices and methods of making them. One particular variation involves the growth of the nanowires on a substrate without the presence of a template, followed by formation of a dielectric layer between the nanowires using PECVD growth of silicon oxide or use of a spin-on glass or polymer material that has been cured. Once the oxide is formed, the wires are partially exposed by an etching process and then the standard conformal layer and TCO layer are deposited on top.

### Applications

The above-described devices find use in a variety of applications including, but not limited to, grid connected power generation for residential buildings, commercial buildings, and power plants, off-grid habitation_power generation, off-grid industrial power generation, outdoor and indoor consumer product, military and space power generation, and so forth.

The following examples are included to demonstrate particular embodiments of the present invention. It should be appreciated by those of skill in the art that the methods disclosed in the examples that follow merely represent exemplary embodiments of the present invention. However, those of skill in the art should, in light of the present disclosure, appreciate that many changes can be made in the specific embodiments described and still obtain a like or similar result without departing from the spirit and scope of the present invention.

### EXAMPLE 1

This Example serves to illustrate the fabrication of a p-n photovoltaic device, in accordance with some embodiments of the present invention.

An example of fabricating a p-n photovoltaic device on a glass substrate is provided. The glass substrate is coated with a conducting layer such as a degenerately-doped polycrystalline silicon (poly-Si) thin film. Aluminum (Al) is deposited on the poly-Si and anodized to form a nanoporous aluminum oxide template. Metal catalyst is electrodeposited in the pores of the template and the substrate is then placed in a CVD reactor for growth of Si nanowires (exemplary elongated nanostructures) using silane, trimethylboron, and hydrogen gases. The device is then placed inside a PECVD reactor and phosphorus-doped amorphous silicon is deposited conformally on the nanowires. ITO is then deposited on the wires by sputtering and patterned contacts formed by a shadow mask during sputtering or by screen printing.

### EXAMPLE 2

This Example serves to illustrate the fabrication of a p-i-n photovoltaic device (with a thin intrinsic tunnel junction), in accordance with some embodiments of the present invention.

An example of fabricating a p- i-n photovoltaic device on a stainless steel substrate is provided. The stainless steel substrate is coated with a conducting barrier layer such as tantalum nitride (Ta₂N). Aluminum is deposited on the Ta₂N and anodized to form a nanoporous aluminum oxide template. Metal catalyst is electrodeposited in the pores of the template and the substrate is then placed in a CVD reactor for growth of Si nanowires using silane, trimethylboron, and hydrogen gases. The device is then placed inside a PECVD reactor and intrinsic amorphous silicon is deposited conformally on the nanowires followed by phosphorus-doped amorphous silicon. ITO is then deposited on the wires by sputtering. Access to the back contact is made by patterning into a sputtered silicon oxide layer and wet etching down to the back metal. Such a process may be used in any of the examples described. Finally, patterned top contacts are formed by a shadow mask during sputtering or by screen printing.

### EXAMPLE 3

This Example serves to illustrate the fabrication of a heterojunction photovoltaic device, in accordance with some embodiments of the present invention.

An example of fabricating a heterojunction photovoltaic device on a glass substrate is provided. The glass substrate is coated with a conducting layer stack such as Ti/Au/W. A thick aluminum film (0.5-5 microns) is deposited on the W by sputtering and anodized to form a nanoporous aluminum oxide template. CdTe nanowires are then formed in the nanopores by electrodeposition and the AAO is etched back by a dry etch process. CdS is then deposited by electron beam evaporation followed by sputtering of ITO. Patterned top contacts are formed by a shadow mask during sputtering or by screen printing.

### EXAMPLE 4

This Example serves to visually illustrate Si nanowires coated with a conformal amorphous Si coating.

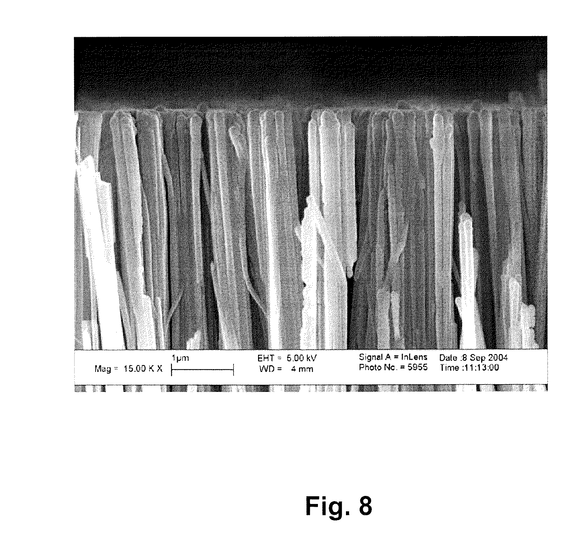

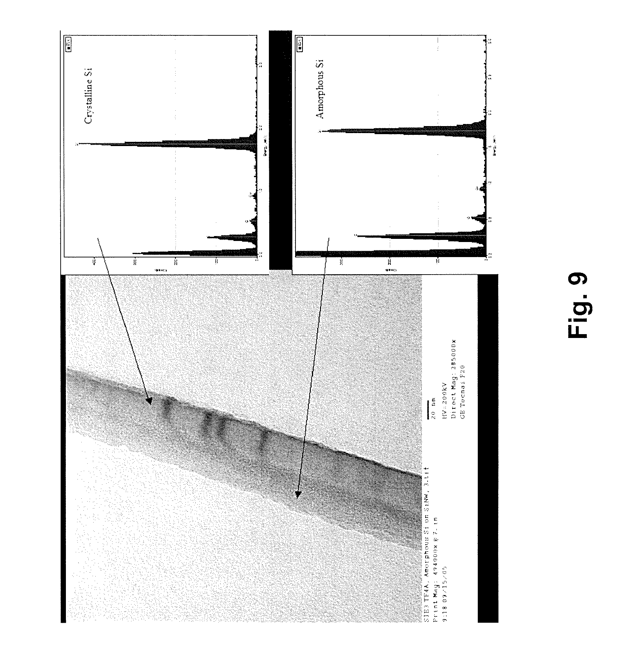

FIGURE 8 is a scanning electron microscopy (SEM) micrograph of a conformal amorphous Si layer on a Si nanowire array, wherein the Si nanowire array was formed via an etching technique. Correspondingly, FIGURE 9 is a transmission electron microscopy (TEM) micrograph (and corresponding energy dispersive X-ray spectra) depicting a coated Si nanowire of the type shown in FIGURE 8;

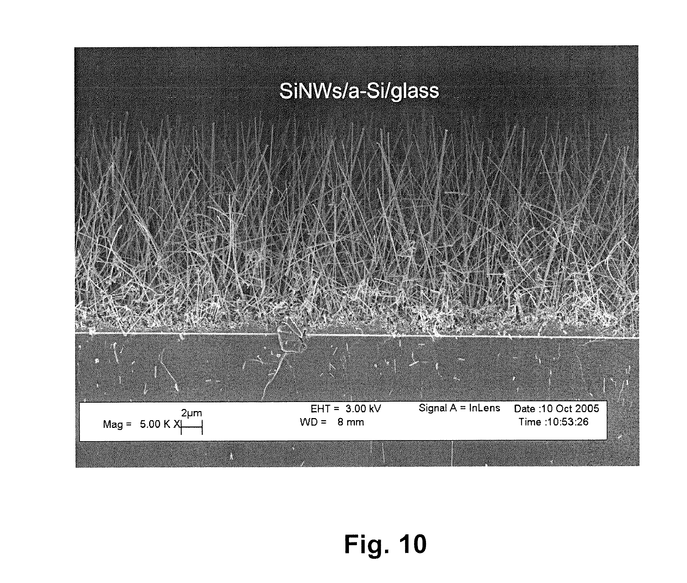

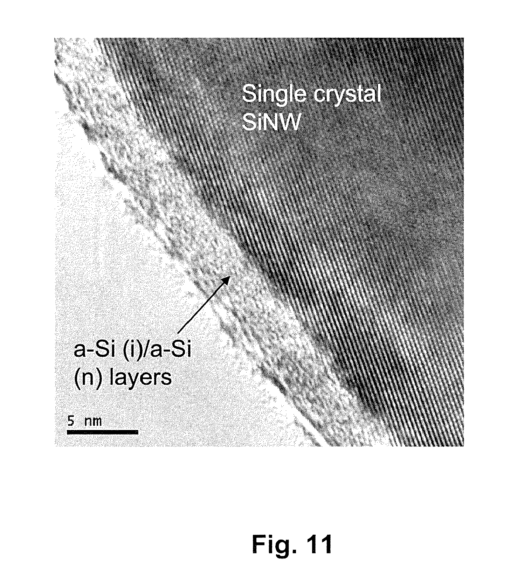

FIGURE 10 is a scanning electron micrograph of a conformal amorphous Si layer on a Si nanowire array, wherein the Si nanowire array was formed via chemical vapor deposition (CVD). Correspondingly, FIGURE 11 is a transmission electron micrograph (and corresponding energy dispersive X-ray spectra) depicting a coated Si nanowire of the type shown in FIGURE 10.

### EXAMPLE 5

This Example shows the inherent advantage of solar cells based on elongated nanostructures as relates to their optical properties.

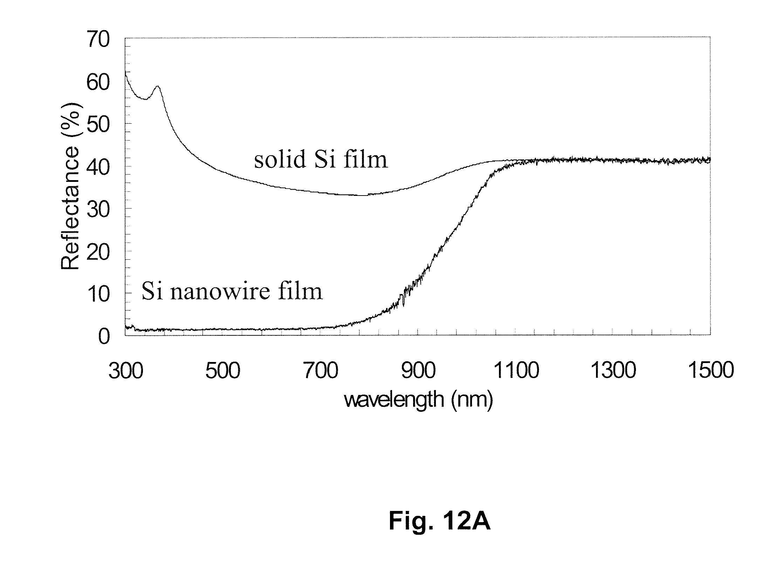

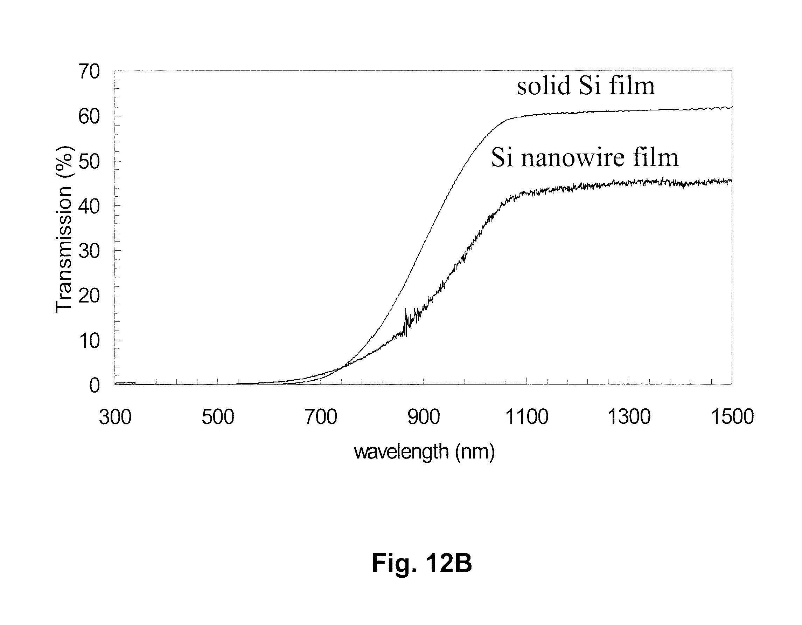

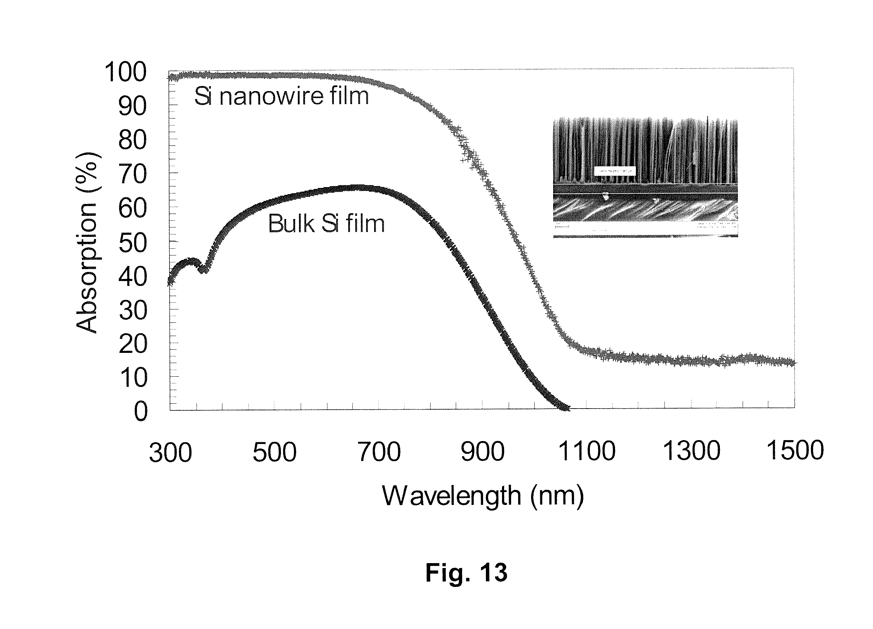

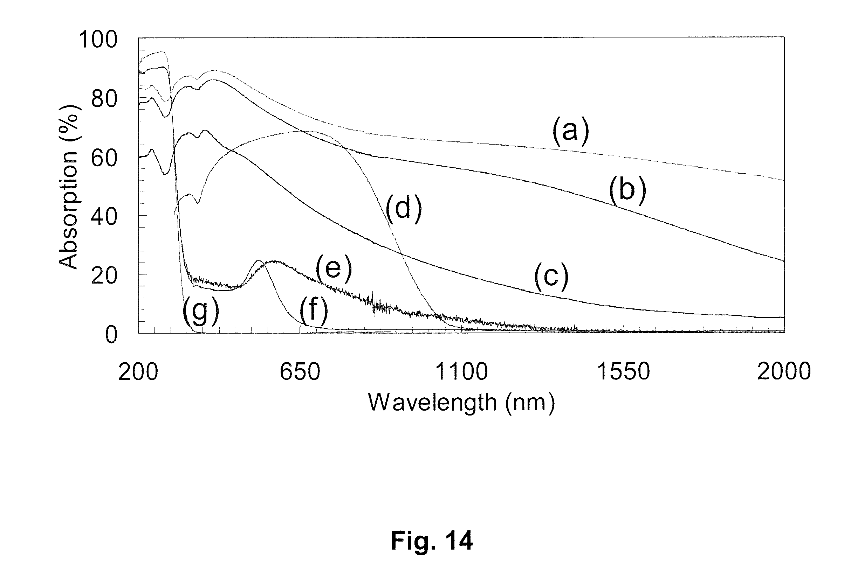

FIGURES 12A and 12B show the total reflectance (12A) and transmission (12B) of a bulk Si thin film and a thin film in which nanowires have been formed. It is clear that there is a dramatic reduction in the reflection for nanowires. There is also a corresponding reduction in transmission for such sample, indicating strong absorptions, as shown in FIGURE 13, where total absorption data for an 1mm thick solid Si thin film and a nanowire film on a glass substrate is shown, and wherein the inset shows a cross-sectional scanning electron micrograph of the sample. A plot of the optical absorption of nanowire films formed by CVD is shown in FIGURE 14, for various catalyst thicknesses: (a) 50 Å, (b) 25 Å, and (c) 10 Å showing enhanced absorption of the nanowire samples compared to (d) a solid Si film; Absorption data for a 50 Å thick Au film on glass (e) before and (f) after thermal annealing at the same temperature and time as the nanowire growth (though without silane flow); and (g) absorption data for a glass substrate similar to that used in the above samples. Once again, there is strong absorption in the nanostructured films compared to the bulk primarily due to light trapping associated with sub-wavelength optical effects.

### EXAMPLE 6

This Example serves to illustrate an exemplary application in which a photovoltaic device described herein may find use, in accordance with some embodiments of the present invention.

In the case of residential or commercial building integrated products, the photovoltaic devices are typically mounted inside a photovoltaic module. They are connected electrically using a variety of known techniques. In the case in which the nanowire solar cells are grown on glass substrates, the glass may be directly integrated into the module, with the original transparent bottom contact now acting as the top contact.

In summary, various aspects of the present invention are directed to photovoltaic devices (e.g., solar cells) comprising elongated nanostructures coated with a thin conformal coating. Depending on the embodiment, such devices can comprise a p-n junction, a p-i-n junction with a thin intrinsic tunneling layer in between the p and n layers, and/or a heterojunction. All types of heterojunction (type I, type II, staggered, etc.) are possible. In all cases, however, at least some of the elongated nanostructures are active photovoltaic (PV) elements in the photovoltaic device. Additionally, the present invention is also directed at methods of making and using such devices. Such photovoltaic or solar cell devices are likely to have cost parity with thin film solar cells, but potentially with higher efficiency as light gets more effectively absorbed and charge separation is better taken care of due to the close proximity to the charge separating junction. The conformal junction also effectively passivates the surface of the elongated nanostructures. Additionally, the ensemble of nanostructures provides excellent light trapping and optical absorption properties.

It will be understood that certain of the above-described structures, functions, and operations of the above-described embodiments are not necessary to practice the present invention and are included in the description simply for completeness of an exemplary embodiment or embodiments. In addition, it will be understood that specific structures, functions, and operations set forth in the above-described referenced patents and publications can be practiced in conjunction with the present invention, but they are not essential to its practice. It is therefore to be understood that the invention may be practiced otherwise than as specifically described without actually departing from the spirit and scope of the present invention as defined by the appended claims. Various aspects and embodiments of the present invention are defined in the following numbered clauses:
1. A photovoltaic device comprising:
   a) a plurality of elongated nanostructures emanating from a porous nanotemplate, the elongated nanostructures being comprised of a semiconducting material having a doping of a first type;
   b) a conformal layer of semiconducting material disposed conformally about the plurality of elongated nanostructures, the conformal layer of semiconducting material having a doping of a second type and, together with the plurality of elongated nanostructures, providing for a charge separating junction; and
   c) top and bottom contacts operable for connecting the device to an external circuit, wherein the bottom contact is in electrical contact with the plurality of elongated nanostructures and the top contact is in electrical contact with the conformal layer.
2. The photovoltaic device of clause 1, further comprising a conductive transparent material disposed on the conformal layer.
3. The photovoltaic device of clause 1 or 2, wherein the elongated nanostructures are selected from the group consisting of nanowires, nanorods, nanotubes, and combinations thereof.
4. The photovoltaic device of any preceding clause, wherein the elongated nanostructures comprise nanowires.
5. The photovoltaic device of any preceding clause, wherein the elongated nanostructures emanate from the porous nanotemplate with a substantially vertical orientation.
6. The photovoltaic device of any preceding clause, wherein the elongated nanostructures emanate from the porous nanotemplate with a random orientation
7. The photovoltaic device of any preceding clause, wherein the elongated nanostructures have a diameter between about 1 nm and about 1 µm, and wherein the elongated nanostructures have a length between about 100 nm and about 100 µm.
8. The photovoltaic device of any preceding clause, wherein the elongated nanostructures possess a doping selected from the group consisting of p-doped and n-doped.
9. The photovoltaic device of any preceding clause, further comprising a substrate on which porous nanotemplate resides.
10. The photovoltaic device of clause 9, wherein the substrate comprises a conductive material selected from the group consisting of metal and degenerately-doped silicon.
11. The photovoltaic device of clause 9 or 10, wherein the substrate comprises a non-conductive material selected from the group consisting of glass and ceramics.
12. The photovoltaic device of any one of clauses 9 to 11, wherein the substrate comprises a conductive layer that serves as the bottom contact, and wherein the conductive layer comprises a material selected from the group consisting of Au, Ti, W, Co, Ta₂N, TiN, and combinations thereof.
13. The photovoltaic device of any preceding clause, wherein the elongated nanostructures comprise a semiconducting material selected from the group consisting of silicon, GaAs, GaP, InP, GaInP, Ge, SiGe, GaInAs, AlGaAs, ZnO, GaN, AIN, InN, BN, Se, CdSe, CdTe, CdS, Cd-O-Te, Cd-Mn-O-Te, ZnTe, Zn-O-Te, Zn-Mn-O-Te, MnTe, Mn-O-Te, oxides of copper, carbon, Cu-In-Ga-Se, Cu-In-Se, and combinations thereof.
14. The photovoltaic device of any preceding clause, wherein the elongated nanostructures comprise silicon (Si).
15. The photovoltaic device of any preceding clause, wherein the elongated nanostructures comprise cadmium telluride (CdTe).
16. The photovoltaic device of any preceding clause, wherein the porous nanotemplate comprises a material selected from the group consisting of anodized aluminum oxide (AAO), silicon dioxide (SiO₂), boron nitride (BN), silicon nitride (Si₃N₄), and combinations thereof.
17. The photovoltaic device of any preceding clause, wherein the porous nanotemplate is an anodized aluminum oxide (AAO) template.
18. The photovoltaic device of any preceding clause, wherein the porous nanotemplate comprises a thickness of between about 0.1 µm and about 100 µm, wherein the porous nanotemplate comprises a pore diameter of between about 1 nm and about 1 µm, and wherein the porous nanotemplate comprises a pore density between about 10⁵ per cm² and about 10¹¹ per cm².
19. The photovoltaic device of any preceding clause, wherein the device is operable for illumination from the top, the bottom, or both.
20. The photovoltaic device of any preceding clause, wherein the conformal layer is n-doped.
21. The photovoltaic device of any preceding clause, wherein the conformal layer is p-doped.
22. The photovoltaic device of any preceding clause, wherein the conformal layer comprises a semiconducting material selected from the group consisting of silicon, GaAs, GaP, InP, GaInP, Ge, SiGe, GaInAs, AlGaAs, ZnO, GaN, AIN, InN, BN, Se, CdSe, CdS, CdTe, Cd-O-Te, Cd-Mn-O-Te, ZnTe, Zn-O-Te, Zn-Mn-O-Te, MnTe, Mn-O-Te, TiOₓ, oxides of copper, carbon, Cu-In-Ga-Se, Cu-In-Se, and combinations thereof.
23. The photovoltaic device of any preceding clause, wherein the conformal layer comprises a semiconducting material selected from the group consisting of amorphous silicon, nanocrystalline silicon, microcrystalline silicon, amorphous SiGe, amorphous SiC, and combinations thereof.
24. The photovoltaic device of any preceding clause, wherein the conformal layer comprises CdSe.
25. The photovoltaic device of any preceding clause, wherein the conformal layer comprises a thickness between about 1 nm and about 100 nm.
26. The photovoltaic device of any preceding clause, wherein the conductive transparent material is a transparent conductive oxide (TCO).
27. The photovoltaic device of clause 26, wherein the transparent conductive oxide is indium-tin-oxide (ITO).
28. The photovoltaic device of clause 26 or 27, wherein the transparent conductive oxide is doped ZnO.
29. The photovoltaic device of any preceding clause, wherein the conductive transparent material comprises a thickness between about 0.05 µm and about 1 µm.
30. A method of making a photovoltaic device, the method comprising the steps of:
   a) growing elongated nanostructures which emanate from a porous nanotemplate, the elongated nanostructures comprising a semiconducting material and having a doping of a first type;
   b) depositing a conformal layer of semiconducting material conformally about the plurality of elongated nanostructures, the conformal layer of semiconducting material having a doping of a second type so as to form a charge separating junction with the underlying elongated nanostructures; and
   c) establishing top and bottom contacts operable for connecting the device to an external circuit, wherein the bottom contact is in electrical contact with the plurality of elongated nanostructures and the top contact is in electrical contact with the conformal layer.
31. The method of clause 30, further comprising a step of depositing a conductive transparent material on the conformal layer.
32. The method of clause 30 or 31, wherein the nanotemplate resides on a substrate, the substrate either providing or supporting the bottom contact.
33. The method of any one of clauses 30 to 32, wherein the elongated nanostructures are grown by a method selected from the group consisting of CVD, MOCVD, PECVD, HWCVD, atomic layer deposition, electrochemical deposition, solution-based chemical deposition, critical point deposition, and combinations thereof.
34. The method of any one of clauses 30 to 33, wherein the elongated nanostructures are catalytically grown from metal nanoparticles.
35. The method of clause 34, wherein the metal nanoparticles comprise a metal selected from the group consisting of gold (Au), cobalt (Co), nickel (Ni), indium (In), gallium (Ga), aluminum (Al), iron (Fe), and combinations thereof.
36. The method of clause 34 or 35, wherein the metal nanoparticles are initially provided at the bottom of the porous nanotemplate.
37. The method of clause 36, wherein the metal nanoparticles are provided by an electrodeposition process.
38. The method of any one of clauses 30 to 37, further comprising a step of etching back the nanoporous template by wet or dry processes so as to more fully expose the elongated nanostructures.
39. The method of any one of clauses 30 to 38, wherein the conformal layer is deposited by a method selected from the group consisting of CVD, MOCVD, PECVD, HWCVD, sputtering, atomic layer deposition, and combinations thereof.
40. The method of any one of clauses 31 to 39, wherein the conductive transparent material is deposited on the conformal layer so as to substantially fill the voids between the nanowires coated with the conformal layer.
41. The method of any one of clauses 31 to 40, wherein the conductive transparent material is deposited by a technique selected from the group consisting of sputtering, sol-gel spinning and pyrolysis, evaporation, CVD, MOCVD, atomic layer deposition, and combinations thereof.
42. A photovoltaic device comprising:
   a) a plurality of elongated nanostructures emanating from a porous nanotemplate, the elongated nanostructures being comprised of a semiconducting material having a doping of a first type;
   b) a first conformal layer of intrinsic semiconducting material disposed conformally about the plurality of elongated nanostructures;
   c) a second conformal layer of semiconducting material disposed conformally about the first conformal layer, the second conformal layer having a doping of a second type, thereby providing for a charge separating junction; and
   d) top and bottom contacts operable for connecting the device to an external circuit, wherein the bottom contact is in electrical contact with the plurality of nanowires and the top contact is in electrical contact with the second conformal layer.
43. The photovoltaic device of clause 42, further comprising a conductive transparent material disposed on the second conformal layer.
44. The photovoltaic device of clause 42 or 43, wherein the elongated nanostructures emanate from the porous nanotemplate with a substantially vertical orientation.
45. The photovoltaic device of any one of clauses 42 to 44, wherein the elongated nanostructures have a diameter between about 1 nm and about 1 µm, and wherein the elongated nanostructures have a length between about 100 nm and about 100 µm.
46. The photovoltaic device of any one of clauses 42 to 45, wherein the elongated nanostructures are p-doped or n-doped.
47. The photovoltaic device of any one of clauses 42 to 46, wherein the elongated nanostructures comprise a semiconducting material selected from the group consisting of silicon, GaAs, GaP, InP, GaInP, Ge, SiGe, GaInAs, AlGaAs, ZnO, GaN, AIN, InN, BN, Se, CdSe, CdTe, Cd-O-Te, Cd-Mn-O-Te, ZnTe, Zn-O-Te, Zn-Mn-O-Te, MnTe, Mn-O-Te, oxides of copper, carbon, Cu-In-Ga-Se, Cu-In-Se, and combinations thereof.
48. The photovoltaic device of any one of clauses 42 to 47, wherein the porous nanotemplate comprises a material selected from the group consisting of anodized aluminum oxide (AAO), SiO₂, BN, Si₃N₄, and combinations thereof.
49. The photovoltaic device of any one of clauses 42 to 48, wherein the porous nanotemplate comprises a thickness of between about 0.1 µm and about 100 µm, wherein the porous nanotemplate comprises a pore diameter of between about 1 nm and about 1 µm, and wherein the porous nanotemplate comprises a pore density between about 10⁵ per cm² and about 10¹¹ per cm².
50. The photovoltaic device of any one of clauses 42 to 49, wherein the second conformal layer is either n-doped or p-doped.
51. The photovoltaic device of any one of clauses 42 to 50, wherein the first and second conformal layers comprise a semiconducting material selected from the group consisting of silicon, GaAs, GaP, InP, GaInP, Ge, SiGe, GaInAs, AlGaAs, ZnO, GaN, AIN, InN, BN, Se, CdSe, CdTe, Cd-O-Te, Cd-Mn-O-Te, ZnTe, Zn-O-Te, Zn-Mn-O-Te, MnTe, Mn-O-Te, oxides of copper, carbon, Cu-In-Ga-Se, Cu-In-Se, and combinations thereof.
52. The photovoltaic device of any one of clauses 42 to 51, wherein the first conformal layer comprises a thickness between about 1 nm and about 50 nm, and wherein the second conformal layer comprises a thickness between about 1 nm and about 1 nm.
53. The photovoltaic device of clause 43, wherein the conductive transparent material is a transparent conductive oxide (TCO).
54. The photovoltaic device of clause 43, wherein the transparent conductive oxide is selected from the group consisting of indium-tin-oxide (ITO) and doped ZnO.
55. The photovoltaic device of clause 43, wherein the conductive transparent material comprises a thickness between about 0.05 µm and 1 µm.
56. A method of making a photovoltaic device, the method comprising the steps of:
   a) growing elongated nanostructures which emanate from a porous nanotemplate, the elongated nanostructures comprising a semiconducting material and having a doping of a first type;
   b) depositing a first conformal layer of intrinsic semiconducting material conformally about the plurality of elongated nanostructures;
   c) depositing a second conformal layer of semiconducting material conformally about the first conformal layer, the second conformal layer having a doping of a second type so as to establish a charge separating junction together with the elongated nanostructures and the first conformal layer; and
   d) establishing top and bottom contacts operable for connecting the device to an external circuit, wherein the bottom contact is in electrical contact with the plurality of elongated nanostructures and the top contact is in electrical contact with the second conformal layer.
57. The method of clause 56, further comprising a step of depositing a conductive transparent material on the second conformal layer.
58. The method of clause 56 or 57, wherein the nanotemplate resides on a substrate, the substrate either providing or supporting the bottom contact.
59. The method of any one of clauses 56 to 58, wherein the elongated nanostructures are grown by a method selected from the group consisting of CVD, MOCVD, PECVD, HWCVD, atomic layer deposition, electrochemical deposition, solution-based chemical deposition, and combinations thereof.
60. The method of any one of clauses 56 to 59, wherein the elongated nanostructures are catalytically grown from metal nanoparticles.
61. The method of clause 60, wherein the metal nanoparticles comprise a metal selected from the group consisting of gold (Au), cobalt (Co), nickel (Ni), indium (In), gallium (Ga), aluminum (A1), iron (Fe), and combinations thereof.
62. The method of clause 60 or 61, wherein the metal nanoparticles are initially provided at the bottom of the porous nanotemplate.
63. The method of any one of clauses 56 to 62, further comprising a step of dry or wet etching the porous nanotemplate.
64. The method of any one of clauses 56 to 63, wherein the first and second conformal layers are deposited by a method selected from the group consisting of CVD, MOCVD, PECVD, HWCVD, sputtering, atomic layer deposition, and combinations thereof.
65. The method of any one of clauses 57 to 64, wherein the conductive transparent material is deposited on the second conformal layer so as to substantially fill the voids between the elongated nanostructures coated with the first and second conformal layers.
66. The method of any one of clauses 57 to 65, wherein the conductive transparent material is deposited using a technique selected from the group consisting of sputtering, sol-gel spinning and pyrolysis, evaporation, CVD, MOCVD, and combinations thereof.
67. A photovoltaic device comprising:
   a) a plurality of elongated nanostructures emanating from a porous nanotemplate, the elongated nanostructures being comprised of a semiconducting material having a first bandgap;
   b) a conformal layer of semiconducting material disposed conformally about the plurality of elongated nanostructures, the conformal layer of semiconducting material having a second bandgap and, together with the plurality of elongated nanostructures, providing for a charge separating heterojunction; and
   c) top and bottom contacts operable for connecting the device to an external circuit, wherein the bottom contact is in electrical contact with the plurality of elongated nanostructures and the top contact is in electrical contact with the conformal layer.
68. The photovoltaic device of clause 67, further comprising a conductive transparent material disposed on the conformal layer.
69. The photovoltaic device of clause 67 or 68, wherein the porous nanotemplate resides on a substrate.
70. The photovoltaic device of any one of clauses 67 to 69, wherein the elongated nanostructures comprise CdTe.
71. The photovoltaic device of clause 70, wherein the conformal layer comprises CdSe.
72. The photovoltaic device of clause 70 or 71, wherein the conformal layer comprises CdS.
73. The photovoltaic device of any one of clauses 67 to 72, wherein the elongated nanostructures comprise CuInS₂.
74. The photovoltaic device of clause 73, wherein the conformal layer comprises TiOₓ.
75. The photovoltaic device of any one of clauses 67 to 74, wherein the elongated nanostructures comprise Cu(In,Ga)Se₂ or Cu(In,Ga)S₂.
76. The photovoltaic device of clause 75, wherein the conformal layer comprises CdS.
77. A method of making a photovoltaic device, the method comprising the steps of:
   a) growing elongated nanostructures which emanate from a porous nanotemplate, the elongated nanostructures comprising a semiconducting material and having a first bandgap;
   b) depositing a conformal layer of semiconducting material conformally about the plurality of elongated nanostructures, the conformal layer of semiconducting material having a second bandgap so as to form a charge separating heterojunction with the underlying elongated nanostructures; and
   c) establishing top and bottom contacts operable for connecting the device to an external circuit, wherein the bottom contact is in electrical contact with the plurality of elongated nanostructures and the top contact is in electrical contact with the conformal layer.
78. The method of clause 77, further comprising a step of depositing a conductive transparent material on the conformal layer.

## Claims

1. A photovoltaic device (100) comprising:
a) a plurality of elongated nanostructures (101) emanating from a porous nanotemplate (102), the elongated nanostructures being comprised of a semiconducting material having a doping of a first type;
b) a conformal layer of semiconducting material (103) disposed conformally about the plurality of elongated nanostructures, the conformal layer of semiconducting material having a doping of a second type and, together with the plurality of elongated nanostructures, providing for a charge separating junction; and
c) top and bottom contacts (105,106) operable for connecting the device to an external circuit, wherein the bottom contact is in electrical contact with the plurality of elongated nanostructures and the top contact is in electrical contact with the conformal layer.

2. The photovoltaic device (100) of claim 1, further comprising a conductive transparent material (104) disposed on the conformal layer (103).

3. The photovoltaic device (100) of any preceding claim, wherein the elongated nanostructures (101) are selected from the group consisting of nanowires, nanorods, nanotubes, and combinations thereof.

4. A photovoltaic device (100) comprising:
a) a plurality of elongated nanostructures (101) emanating from a porous nanotemplate, the elongated nanostructures being comprised of a semiconducting material having a doping of a first type;
b) a first conformal layer of intrinsic semiconducting material (103) disposed conformally about the plurality of elongated nanostructures;
c) a second conformal layer of semiconducting material (404) disposed conformally about the first conformal layer, the second conformal layer having a doping of a second type, thereby providing for a charge separating junction; and
d) top and bottom contacts (105,106) operable for connecting the device to an external circuit, wherein the bottom contact is in electrical contact with the plurality of nanowires and the top contact is in electrical contact with the second conformal layer.

5. The photovoltaic device (100) of claim 4, further comprising a conductive transparent material (405) disposed on the second conformal layer (404).

6. The photovoltaic device (100) of claim 4 or claim 5, wherein the elongated nanostructures (101) emanate from the porous nanotemplate with a substantially vertical orientation.

7. A photovoltaic device (100) comprising:
a) a plurality of elongated nanostructures (101) emanating from a porous nanotemplate, the elongated nanostructures being comprised of a semiconducting material having a first bandgap;
b) a conformal layer of semiconducting material (103) disposed conformally about the plurality of elongated nanostructures, the conformal layer of semiconducting material having a second bandgap and, together with the plurality of elongated nanostructures, providing for a charge separating heterojunction; and
c) top and bottom contacts (105, 106) operable for connecting the device to an external circuit, wherein the bottom contact is in electrical contact with the plurality of elongated nanostructures and the top contact is in electrical contact with the conformal layer.

8. The photovoltaic (100) device of claim 7, further comprising a conductive transparent material disposed on the conformal layer.

9. The photovoltaic device (100) of claim 7 or claim 8, wherein the porous nanotemplate resides on a substrate.

10. A method of making a photovoltaic device (100), the method comprising the steps of:
a) growing elongated nanostructures (101) which emanate from a porous nanotemplate (102), the elongated nanostructures comprising a semiconducting material and having a first bandgap;
b) depositing a conformal layer of semiconducting material (103) conformally about the plurality of elongated nanostructures, the conformal layer of semiconducting material having a second bandgap so as to form a charge separating heterojunction with the underlying elongated nanostructures; and
c) establishing top and bottom contacts (105,106) operable for connecting the device to an external circuit, wherein the bottom contact is in electrical contact with the plurality of elongated nanostructures and the top contact is in electrical contact with the conformal layer.
